# EUROPÄISCHE PATENTSCHRIFT

(11) **EP 1 715 592 B1**
(45) Veröffentlichungstag und Bekanntmachung des Hinweises auf die Patenterteilung: **08.02.2012**
(21) Anmeldenummer: 06112184.4
(22) Anmeldetag: 03.04.2006
(51) Int. Cl.: H04B 1/26, H03J 1/00

(54) **Funkwellenempfänger**
Radio receiver
Récepteur radio

(30) Priorität: 19.04.2005 DE 102005018079
(43) Veröffentlichungstag der Anmeldung: 25.10.2006
(73) Patentinhaber: ROBERT BOSCH GMBH, 70442 Stuttgart (DE)
(72) Erfinder: Kottschlag, Gerhard, 31139, Hildesheim (DE); Vogel, Guenter, 72760, Reutlingen (DE); Passoke, Jens, 30966, Hemmingen (DE); Schnitzer, Reiner, 72762, Reutlingen (DE)

(56) Entgegenhaltungen:
- EP-A2- 0 883 238
- EP-A2- 1 195 899
- EP-A2- 1 492 243
- WO-A1-96/23354
- WO-A2-2005/122397
- US-B1- 6 473 606

## Beschreibung

Die Erfindung betrifft einen Funkwellenempfänger mit einer auf ausgewählte Empfangsfrequenzen einstellbaren Empfangseinheit, die einen Oszillator zur Erzeugung eines abstimmbaren Quellsignals und daraus abgeleitet eines Mischeransteuersignals sowie einen Mischer zur Umsetzung eines Empfangssignals auf eine Zwischenfrequenz hat, wobei die Schwingfrequenz des Oszillators mindestens um das Dreifache größer als die größte zur Auswahl vorgesehenen Empfangsfrequenz ist und ein Vorteiler mit wahlweise einstellbaren Teilerfaktoren zur Reduzierung der Schwingfrequenz des Oszillators auf die ausgewählte Mischeransteuerfrequenz zwischen dem Oszillator und dem Mischer vorgesehen ist.

In herkömmlichen Funkwellenempfängern, beispielsweise zum Empfang von frequenzmodulierten (FM) und/oder amplitudenmodulierten (AM) Fundfunksignalen, wird das Mischeransteuersignal in der Regel mit einem spannungsgesteuerten Oszillator(Voltage Controlled Oscillator, VCO) erzeugt. Es sind teilintegrierte Oszillatoren verfügbar, die von einem externen Resonanzkreis gesteuert werden, der unter anderem eine Kapazitätsdiode (Varaktor), eine Induktivität und gegebenenfalls eine feste Kapazität hat.

Eine Vollintegration aller aufgeführten Bauteile ist erst bei Oszillatoren möglich, die im Frequenzbereich oberhalb ca. 1GHz schwingen. Der Einsatz solcher höherschwingender Oszillatoren für den Empfang von Frequenzen in den deutlich niederfrequenteren Fundfunkbändern ist im Prinzip möglich: Aus der WO 01/20796 A1 ist ein Homodynempfänger bekannt, bei dem der Oszillator mit der doppelten Mischansteuerfrequenz betrieben wird. Das Ausgangssignal des Oszillators wird mit einem Teiler, der auf den fester Teilerfaktor von 2 eingestellt ist, auf die Mischansteuerfrequenz herabgeteilt. Damit wird ein Zweibandempfänger und Sender geschaffen, der für zwei unterschiedliche Empfangs- und Sendefrequenzbänder ausgelegt ist.

Allerdings beschränken einige Eigenschaften der integrierten Bauteile die realisierbaren Schaltungskonzepte und/oder die erreichbare Empfangsqualität. Beispielsweise zeigen integrierte Kapazitätsdioden wesentlichen Einfluss auf die Größe und Lage des abstimmbaren Frequenzbepeichs.

Bei einer typischen Zwischenfrequenz (ZF) von 10,7 MHz und oberschwingendem Betrieb ist beispielsweise für einen Frequenzbereich von 87,5 bis 108;0 MHz(FM-Band in Europa) ein Abstimmbereich von ± 10% erforderlich, um einen solchen spannungsgesteuerten Oszillator in einem entsprechenden FN-Rundfunkempfäner einsetzen zu können. Für einen FN-Weltempfänger mit einem Frequenzbereich von 65,8 bis 108,0-MHz ist ein Abstimmbereich von ± 25% notwendig. Beides ist nur mit erheblichem Aufwand oder Abstrichen bei der Empfangsleistung (z. B. Stärke des Restrauschens bei Stereoempfang) möglich.

Ein weiteres Problem ist die Streuung der Mittenfrequenz der spannungsgesteuerten Oszillatoren um etwa ± 15%, die durch die Prozessstreuungen im Kapazität- und Induktionswet des LC-Resonanzkreises von spannungsgesteuerten Oszillatoren bedingt ist. Auch diese Streuung muss im benötigten Abstimmbereich bei der Auslegung des Oszillators vorgehalten werden.

Aus der WO 2005/122397 A2 geht ein Funkwellenempfänger hervor, der einen abstimmbaren Oszillatorkreis aufweist, der ein Oszillatorsignal bereitstellt. Ein steuerbarer Frequenzteilerschaltkreis stellt ein herunter-geteiltes-Frequenzsignal auf der Basis des Oszillatorsignals zur Verfügung. Das heruntergeteilter Frequenzsignal hat eine Frequenz, die der Frequenz des Oszillatorsignals geteilt durch einen Teilungsfaktor entspricht. Der steuerbare Frequenzteilerschaltkreis stellt verschieden Teilungsfaktoren bereit, z. B. 4, 5, 6, 7.

Aus der WO 96/23354 A1 ist ein Funkwellenempfänger bekannt, der eine Heterodyn-Stufe mit einem Oszillator und einem Mischer aufweist. Dem Oszillator ist ein steuerbarer Frequenzteiler nachgeschaltet, der die Oszillatorsignale in eine andere Frequenz konvertiert, so das der Funkwellenempfänger einen Empfang im UHF- und VHF-Band ermöglicht.

Aus der US 6,473,606 B 1 geht ein Funkwellenempfänger hervor, der einen gemeinsamen Mischer und eine Zwischenfrequenz sowohl für AM- als auch für FM-Radiosignale aufweist. Zur Kostenteduzierung wird vor geschlagen, bei niedrigen Frequenzen zu arbeiten, so dass kostengünstige Keramikfilter und integrierte Filter in einem IC statt aufwendiger Kristallfilter verwendet werden können. Durch den gemeinsamen Mischer sowohl für AM- als auch für FM-Signale kann zudem Schaltkreisfläche gespart werden.

Aufgabe der Erfindung ist es einen verbesserten Funkwellenempfänger zu schaffen, der unter Verwendung eines vollintegrierten Oszillators mit hoher Signalqualität dennoch einen hinreichend großen Abstimmbereich für die Mischeransteuerfrequenz aufweist.

Die Aufgabe wird mit dem gattungsgemäßen Funkwellenempfänger erfindungsgemäß dadurch gelöst, dass der Mischer wahlweise mit oberschwingendem oder unterschwingendem Ansteuersignal betrieben ist. Dann kann der Abstimmbereich nochmals reduziert werden. Für den Abgleich und Betrieb das Oszillators steigt der Steuerungsaufwand allerdings an.

Durch die Anhebung der Schwingfrequenz des Oszillators auf mindestens das Dreifache der größten zur Auswahl vorgesehenen Empfangsfrequenz, die typischerweise im Bereich einiger GHz liegt, und Nutzung eines Vorteilers können unterschiedliche Frequenzbänder durch verschiedene Teilerwerte eingestellt werden. Der eigentliche Oszillator-Abstimmbereich kann dann für jedes Frequenzband reduziert werden. Der eigentliche Oszillator-Abstimmbereich muss dann vorzugsweise nur noch so-groß sein, dass die Frequenzbänder des Mischansteuersignals lückenlos aneinander anschließen oder sich teilweise überlappen.

Ein solcher-Oszillator, der im Bereich einiger GHz schwingt, kann wie oben beschrieben mit modernen Halbleitertechnologien als komplett integrierte Schaltung realisiert werden. Sofern sein Abstimmbereich Schmalbandig ausgelegt ist, werden die hohen Anforderungen bezüglich der spektralen Reinheit des Ausgangssignals erfüllt.

Die Schwingfrequenz des Oszillators und die Teilerfaktoren für den Vorteiler sind vorzugsweise zur Selektion unterschiedlicher Empfangsfrequenzbänder aufeinander abgestimmt. Mit Hilfe der Teilerfaktoren des Vorteilers können somit unterschiedliche Frequenzbereiche eingestellt werden.

Besonders vorteilhaft ist es, wenn zwischen dem Vorteiler und dem Oszillators ein Ansteuerteiler vorgesehen ist. Dieser Ansteuerteiler hat vorzugsweise einen fest eingestellten Teilerfaktor, der nicht wahlweise selektierbar ist. Durch den Ansteuerteiler wird die selektiv herabgeteilter Ausgangsfrequenz des Oszillators nochmals in an sich bekannter Weise um einen festen Teilerfaktor auf die Mischeransteuerfrequenz herabgeteilt. Vorzugsweise wird vom Ansteuerteiler ein Mischeransteuersignal mit einem Tastverhältnis von 50% : 50% bereitgestellt, was zur Unterdrückung von Störsignalen und Mischprodukten dient, die durch die 2. Oberwelle des Mischeransteuersignals (doppelte Frequenz der Grundwelle des Mischeransteuersignals) entstehen können. Besonders vorteilhaft ist auch ein Ansteuerteiler mit zwei Ausgängen, die einen Phasenversatz von 90° aufweisen. Solche Signale sind als Mischeransteuersignale für spiegelfrequenzunterdrückende Mischer (Image Rejection mixer, IMR-mixer) geeignet. Beide Anforderungen lassen sich besonders einfach mit einem Teiler realisieren, der ein festes Teilungsverhältnis von vier (oder einem Vielfachen von vier) aufweist.

Besonders vorteilhaft ist der Betrieb des Oszillators an einer Phasenregelschleife (phase Locked Loop, PLL). Der Ausgang des Oszillators oder ein Ausgang des Vorteilers ist vorzugsweise mit einem Abstimmteiler und der Ausgang de Abstimmteilers mit einem ersten Eingang eines Phasenvergleichers verbunden. Ein zweiter Eingang des Phasenvergleichers ist für ein Referenzfrequenzsignal vorgesehen. Der Ausgang des Phasenvergleichers steht direkt oder indirekt in Verbindung mit einem Steuereingang des Oszillators, beispielsweise über ein Schleifenfilter zwischen dem Ausgang des Phasenvergleichers und dem Steuereingang des Oszillators. Der Phasenvergleicher ist zur Bestimmung der Phasendifferenz zwischen dem Ausgangssignal des Abstimmteilers und dem Referenzfrequenzsignal und Bereitstellung eines Phasendifferenzsignals als Ausgangssignal ausgebildet. Auf diese Weise kann einfach und qualitativ hochwertig eine Phasenregelung für den Oszillator realisiert werden.

Das Referenzfrequenzsignal wird vorzugsweise mit einem Referenzoszillator und einem an den Ausgang des Referenzoszillators geschalteten Referenzteiler erzeugt. Mit Hilfe des Referenzteilers wird das vom Referenzoszillator bereitgestellte Frequenzsignal, das ein Vielfaches der Referenzfrequenz beträgt, herabgeteilt.

Zur Reduktion der Störempfmdlichkeit und des Phasenrauschens des Ausgangssignals eines spannungsgesteuerten Oszillators ist es vorteilhaft, den Abstimmbereich nochmals weiter in sich überlappende Segmente zu zerlegen. Hierzu beinhaltet der Oszillatorresonanzkreis vorzugsweise eine Mehrzahl von wahlweise ein- oder ausschaltbaren kapazitiven Elementen und mindestens ein kontinuierlich einstellbares kapazitives Element zur Einstellung von Frequenzen eines Abstimmbereichssegments.

Besonders vorteilhaft ist es, den tatsächlichen Abstimmbereich des Oszillators zu ermitteln oder abzuschätzen. Dies kann bei der Fabrikation des Empfängers oder der Empfangseinheit, bei der ersten Inbetriebnahme, bei jeder erneuten Inbetriebnahme, in definierten Zyklen und/oder permanent erfolgen. Hieraus kann individuell eine Strategie zum Wechsel zwischen verschiedenen Abstimmbereichen abgeleitet werden, oder die Oszillatoreigenschaften dienen der Zuordnung des jeweiligen Exemplars zu einer Klasse sich ähnlich verhaltender Oszillatoren, z.B. zur Zuordnung zu einer Gruppe von Oszillatoren, deren Mittenfrequenz innerhalb eines enger spezifizierten Bereichs liegt.

Besonders vorteilhaft ist die Messung der frequenzbestimmenden Größe, z.B. der Abstimmspannung des spannungsgesteuerten Oszillators. Bei Anwahl einer mittleren Schwingfrequenz gibt die Größe der Abstimmspannung darüber Auskunft, wie weit der gerade getestete Oszillator vom typischen Mittelwert abweicht. Daraus kann die durch Prozesstoleranzen bedingte Verschiebung seines Abstimmbereichs abgeleitet werden. Alternativ kann die Schwingfrequenz solange erhöht bzw. erniedrigt werden, bis die Abstimmspannung einen definierten Grenzwert erreicht hat. Sofern der Grenzwert der gerade noch zulässigen Abstimmspannung entspricht, ist mit der eingestellten Frequenz das Ende des Abstimmbereichs ermittelt.

Besonders vorteilhaft ist die Auswertung eines Signals, dass das Einrasten der Phasenregelschleife (PLL) anzeigt. Solch ein Signal wird in vielen PLLs dann ausgegeben, wenn der Phasenvergleicher ermittelt, dass nur noch ein geringer definierter Restphasenversatz zwischen dem herunter geteilten Oszillatorsignal und dem ggf. auch herunter geteilten Referenzsignal besteht. Bei einigen Detektoren muss dieses Kriterium über einen definierten Zeitraum permanent erfüllt sein, um die Ausgabe des Einrast-Erkennungssignals freizugeben. Somit kann durch Verstellen der Oszillatorfrequenz und anschließendem Test des Einrast-Erkennungssignals festgestellt werden, ob der Oszillator die vorgegebene Frequenz erreicht hat. Durch den Test mehrerer Frequenzen lässt sich der Abstimmbereich ermitteln, der dann in der Regel noch um einen Sicherheitsbereich am Abstimmbereichsanfang und -ende reduziert wird, um unter allen Betriebsbedingungen (z.B. Temperaturschwankungen) einen stabilen Betrieb der Empfangseinheit zu gewährleisten.

Die Erfindung wird nachfolgend anhand der beigefügten Zeichnungen beispielhaft näher erläutert. Es zeigen:
Figur 1 - ein Blockschaltbild eines Funkwellenempfängers mit Oszillator, Mischer und Vorteiler;
Figur 2 - ein Blockschaltbild eines spannungsgesteuerten Oszillators mit diskret schaltbaren kapazitiven Abstimmelementen und einem kontinuierlich einstellbaren kapazitiven Abstimmelement.

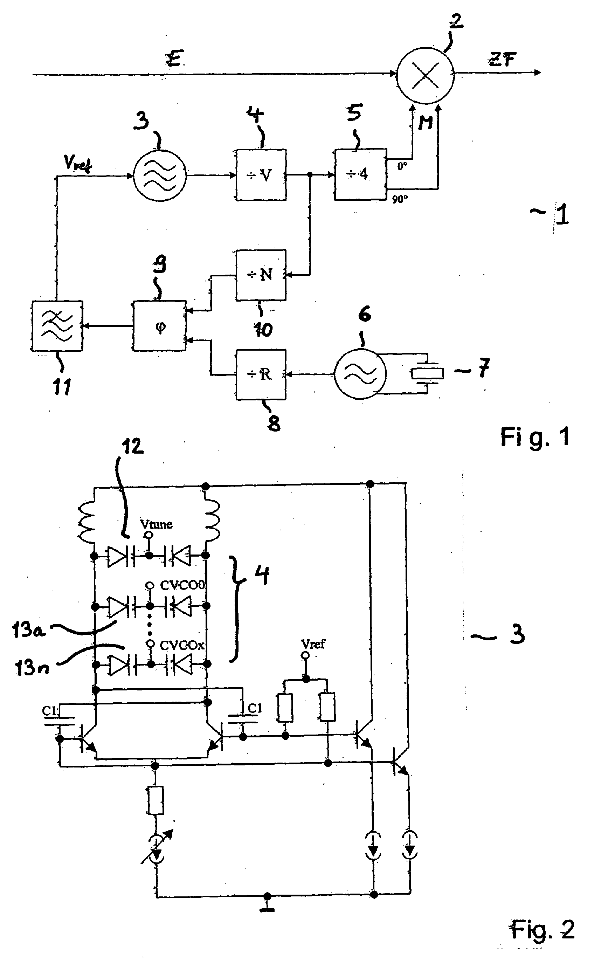

Die Figur 1 zeigt ein Blockschaltbild einer Ausführungsform des erfindungsgemäßen Funkwellenempfängers 1. Der Funkwellenempfänger 1 hat einen Mischer 2, um in bekannter Weise ein Empfangssignal E von einer Antenne mit einem Mischeransteuersignal M auf ein Zwischenfrequenzsignal ZF von beispielsweise 10,7 MHz herabzumischen. Das Mischeransteuersignal M legt dabei die ausgewählte Empfangsfrequenz innerhalb des Empfangssignals E fest. Das Empfangssignal E kann beispielsweise mehrere Frequenzbänder umfassen, wie z. B. das FM-Band von 65,8 MHz bis 108,0 MHz. Um für einen solchen breiten Frequenzbereich des Empfangssignals E mit dem hierfür erforderlichen weiteren Abstimmbereich ein Mischeransteuersignal M mit hinreichender Qualität generieren zu können, wird der benötigte Abstimmbereich des zur Erzeugung des Mischeransteuersignals M genutzten spannungsgesteuerten Oszillators VCO 3 durch Einsatz eines Vorteilers 4 wie nachfolgend beschrieben reduziert. Die Schwingfrequenz des spannungsgesteuerten Oszillators 3 wird so ausgelegt, dass sie mindestens das Dreifache der Mischeransteuerfrequenz beträgt, im vorliegenden Beispiel in den Bereich einiger GHz. Die Teilerfaktoren des Vorteilers 4 sind auf verschiedene geeignete Werte einstellbar, wodurch sich die Generierung von Mischeransteuerfrequenzen in unterschiedlichen Frequenzbereichen ergibt. Damit muss der eigentliche Abstimmbereich des spannungsgesteuerten Oszillators 3 nur noch so groß sein, dass diese einzelnen Frequenzbereiche des Mischeransteuersignals M lückenlos aneinander anschließen oder sich überlappen, zumindest für den Frequenzbereich, der für die Verarbeitung des gewünschten Empfangsfrequenzbereichs erforderlich ist.

Das mit dem Vorteiler 4 herabgeteilte Oszillatorsignal wird mit einem Ansteuerteiler 5 in bekannter Weise weiter um einen fest eingestellten Teilerfaktor, beispielsweise einem Teilerfaktor von 4, weiter herab geteilt und in zwei orthogonal zueinander stehende Signale mit einer Phasenlage von 0° und 90° aufgeteilt, um den Spiegelfrequenzempfang unterdrückenden Mischer 2 (IMR-Mischer) anzusteuern. Mit der Möglichkeit, die Phasenlage dieser Signale zu tauschen, kann der Mischer 2 wahlweise mit oberschwingendem oder unterschwingendem Mischeransteuersignal M betrieben werden. Durch geschickte Wahl der Frequenzbänder und Teilerverhältnisse kann der Abstimmbereich dadurch nochmals reduziert werden, indem nicht mehr eine Überlappung der Abstimmfrequenzbereiche angestrebt wird, sondern die Lücken im Empfangsbereich durch Umschalten der Empfangslage (unter- bzw. oberschwingend) geschlossen werden. Dies führt allerdings zu einem erhöhten Steuerungsaufwand beim Abgleich und dem Betrieb des Funkwellenempfängers 1.

Durch Verringerung des Teilerfaktors können bei gleich bleibendem Abstimmbereich des spannungsgesteuerten Oszillators 3 neben dem Frequenzband eines FM-Weltempfängers von 65,8 MHz bis 108 MHz auch beispielsweise das USA-Wetterband von 162,4 MHz bis 162,55 MHz und mit zusätzlichen Teilerstufen oder einstellbaren Teilerwerten auch Frequenzbänder im Lang,- Mittel- und Kurzwellenbereich (AM-Bänder) empfangen werden.

Ein für Weltempfang ausgelegter FM-Funkwellenempfänger 1 hat beispielsweise einen spannungsgesteuerten Oszillator 3 mit einem Abstimmbereich von 3,42 bis 3,92 GHz. Mit den zu erwartenden Prozesstoleranzen bei einem integrierten spannungsgesteuerten Oszillator 3 kann dieses Frequenzband nach unten auf 2,91 bis 3,33 GHz oder nach oben auf 3,935 bis 4,505 GHz verschoben sein. Der Abstimmbereich beträgt ±7,1%. In der folgenden Tabelle ist zu erkennen, wie durch die Wahl des Teilerfaktors für den Vorteiler 4 das komplette FM-Empfangsband oberschwingend abgedeckt werden kann. Das Mischeransteuersignal M liegt dabei in einem Frequenzbereich von 76,5 bis 118,7 MHz.

| Teilerfaktor für Vorteiler | Typischer Abstimmbereich in MHz | | Verschiebung nach unten durch Prozess-Toleranz (-15%) in MHz | | Verschiebung nach oben durch Prozess-Toleranz (+15%) in MHz | |
|---|---|---|---|---|---|---|
| | min | max | min | max | min | max |
| VCO: | 3420 | 3920 | 2910 | 3330 | 3935 | 4505 |
| | | | | | | |
| 6 | 142,5 | 163,3 | 121,3 | 138,7 | 164,0 | 187,7 |
| 7 | 122,2 | 140,0 | **104,0** | **118,9** | 140,6 | 160,8 |
| 8 | **106,9** | **122,5** | **91,0** | **104,0** | 123,0 | 140,7 |
| 9 | **95,0** | **108,8** | **80,9** | **92,5** | **109,4** | 125,1 |
| 10 | **85,5** | **98,0** | **72,8** | **83,2** | **98,4** | **112,6** |
| 11 | **77,8** | **89,0** | 66,2 | 75,6 | **89,5** | **102,3** |
| 12 | **71,3** | **81,6** | 60,7 | 69,3 | **82,0** | **93,8** |
| 13 | 65,8 | 75,3 | 56,0 | 64,0 | **75,7** | **86,6** |
| 14 | 61,1 | 70,0 | 52,0 | 59,4 | 70,3 | 80,4 |

Für den typischen Abstimmbereich sind für den Vorteiler 4 die Teilerfaktoren zwischen 8 und 12 notwendig. Um auch die Prozesstoleranzen des Oszillators 3 auszugleichen werden insgesamt die Teilerwerte zwischen 7 und 13 benötigt.

Wenn man einige Teilbereiche mit oberschwingender Mischlage, andere Bereiche hingegen unterschwingend abdeckt, so kann man den notwendigen Abstimmbereich des Oszillators 3 weiter reduzieren, indem die entstehenden Lücken durch den Betrieb in der jeweils anderen Mischlage geschlossen werden. Ein solcher ebenfalls für Weltempfang ausgelegter FM-Funkwellenempfänger 1 hat beispielsweise einen spannungsgesteuerten Oszillator 3 mit einem Abstimmbereich von 3,52 bis 3,92 GHz. Mit den gleichen Prozesstoleranzen, die im vorstehenden Beispiel angenommen wurden, kann dieses Frequenzband nach unten auf 2,995 bis 3,33 GHz oder nach oben auf 4,045 bis 4,505 GHz verschoben sein. Der Abstimmbereich beträgt nur noch ± 5,5%. In der folgenden Tabelle ist für einen Oszillatorexemplar mit -15% Prozesstoleranz zu erkennen, wie durch die Wahl des Teilerfaktors für den Vorteiler 4 und Umschaltung zwischen oberschwingender und unterschwingender Mischlage das komplette FM-

| Teilerfaktor für Vorteiler | Mischlage: unterschwingend oder oberschwingend | | Verschiebung nach unten durch Prozess-Toleranz (-15%) in MHz | | Empfangsfrequenz in MHz | |
|---|---|---|---|---|---|---|
| | | | min | max | min | max |
| VCO: | | | 2995 | 3330 | | |
| | | | | | | |
| 7 | | Oberschw. | 107,0 | 118,9 | 96,3 | 108,2 |
| 9 | Unterschw. | | 83,2 | 92,5 | 93,9 | 103,2 |
| 10 | Unterschw. | | 74,9 | 83,2 | 85,6 | 93,9 |
| 8 | | Oberschw. | 93,6 | 104,0 | 82,9 | 93,3 |
| 11 | Unterschw. | | 68,1 | 75,6 | 78,8 | 86,3 |
| 9 | | Oberschw. | 83,2 | 92,5 | 72,5 | 81,8 |
| 10 | | Oberschw. | 74,9 | 83,2 | 64,2 | 72,5 |

Empfangsband abgedeckt werden kann. Bei Oszillatoren mit nominellem Abstimmbereich oder anderen Exemplarabweichungen bis hin zu +15% verschieben sich die Frequenzbereiche entsprechend.

Für den exemplarisch aufgeführten Abstimmbereich sind für den Vorteiler 4 die Teilerfaktoren zwischen 7 und 11 notwendig. Unter Berücksichtigung der Prozesstoleranzen bis +15% ergibt sich ein notwendiger Teilerbereich bis hinauf zum Teilerfaktor 14.

Die Frequenzregelung des Oszillators 3 erfolgt mit einer PLL, die mit einem Referenzoszillator 6 und dessen Referenzquarz 7 betrieben wird. Das Ausgangssignal des Referenzoszillators 6 wird mit einem Referenzteiler 8 herab geteilt und in einem Phasenvergleicher 9 mit dem durch einen Abstimmteiler 10 um den Abstimmteilerfaktor n herabgeteilten Ausgangssignal des Vorteilers 4 verglichen. Das Phasendifferenzsignal am Ausgang des Phasenteilers wird über ein Schleifenfilter 11 als Regelungssignal dem Oszillator 3 zugeführt.

In einer Variante des Ausführungsbeispiels wird die Abstimmspannung V_{ref} am Ausgang des Schleifenfilters 11 auch einem Anlog-Digital-Wandler zugeführt. Zur Ermittlung des tatsächlich zur Verfügung stehenden Abstimmbereichs dieses Oszillatorexemplars wird beispielsweise bei der ersten Inbetriebnahme der Empfangseinheit die niedrigste und die höchste einstellbare Oszillatorfrequenz ermittelt. Dies erfolgt bei einer geeigneten Einstellung des Vorteilers 4 durch mehrmaliges Umprogrammieren des Abstimmteilers 10 und anschließender Messung der Abstimmspannung V_{ref} am Ausgang des Schleifenfilters 11. Sofern diese Spannung innerhalb eines zulässigen Spannungsbereichs bleibt, kann der Oszillator auf der eingestellten Frequenz betrieben werden.

Die niedrigste und die höchste so ermittelte zulässige Oszillatorfrequenz dieses Exemplars oder gleichwertige Informationen werden im Speicher (z.B. Flash-ROM) des Empfangssystems abgelegt. Gleichwertige Informationen können beispielsweise die Teilerwerte des Abstimmteilers 10 sein, die gerade noch zu einer zulässigen Abstimmspannung geführt haben, oder die Einstufung des Oszillatorexemplars in eine Klasse ähnlicher Exemplare, die z.B. alle Exemplare zusammenfasst, die eine prozessbedingte Abweichung vom Nominalfrequenzbereich um -10% bis -5% aufweisen.

Die Figur 2 lässt eine Ausführungsform des Funkwellenempfängers 1 erkennen, bei dem zur Reduktion der Störempfindlichkeit und des Phasenrauschens des Ausgangssignals des Oszillators 3 der Abstimmbereich nochmals weiter in sich überlappende Segmente zerlegt wird. Dies wird erreicht, indem statt einer einzigen kontinuierlich einstellbaren kapazitiven Abstimmschaltung 12 mehrere binär gewichtete und geschaltete, d. h. wahlweise ein- oder ausschaltbare Abstimmschaltungen 13a, ..., 13n parallel zu einer kontinuierlich abstimmbaren Abstimmschaltung 12 geschaltet sind. Die Abstimmschaltungen 12, 13 können beispielsweise aus jeweils zwei gegenpolig miteinander verbundenen Varaktoren aufgebaut sein, deren Verbindungsstelle bei der kontinuierlich einstellbaren Abstimmschaltung 12 mit einem Abstimmsignal Vₜᵤₙₑ und bei den binär gewichteten und geschalteten Abstimmschaltungen 13 wahlweise mit einem von zwei festgelegten Spannungspotentialen beaufschlagt wird.

## Patentansprüche

1. Funkwellenempfänger (1) mit einer auf ausgewählte empfangsfrequenzen einstellbaren Empfangseinheiit, die einen Mischer (2) zum Mischen des Empfangssignals (E) mit einem Mischersignal (M) und einen Oszillator (3) zur Erzeugung des Mischersignals (M) mit einer wahlweise abstimmbaren Mischeransteuerfrequenz hat, wobei die Schwingfrequenz des Oszillators (3) mindestens um das um das Dreifache größer als die größte zur Auswahl vorgesehene Empfangsfrequenz ist und ein Verteiler (4) mit wahlweise einstellbaren Teilerfaktoren zur Reduzierung der Schwingfrequenz des Oszillators (3) auf die ausgewählte Mischeransteuerungsfrequenz zwischen dem Oszillator (3) und dem Mischer (2) vorgesehen ist, **dadurch gekennzeichnet, dass** der Mischer (2) wahlweise mit oberschwingendem oder unterschwingendem Mischeransteuersignal (M) betrieben ist.

2. Funkwellenempfänger (1) nach Anspruch 1, **dadurch gekennzeichnet, dass** die Schwingfrequenz des Oszillators (3) und die Teilerfaktoren für den Vorteiler-(4) zur Selektion unterschiedlicher Empfangsfrequenzbänder aufeinander abgestimmt sind.

3. Funkwellenempfänger (1) nach Anspruch 1 oder 2, **dadurch gekennzeichnet, dass** mindestens zwei der durch unterschiedliche Teilerfaktoren für den Vorteiler (4) einstellbaren Empfangsfrequenzbänder lückenlos aneinander anschließen oder sich überlappen

4. Funkwellenempfänger (1) nach einem der vorhergehenden Ansprüche, **dadurch gekennzeichnet, dass** mindestens zwei der durch unterschwingenden oder oberschwingenden Betrieb einstellbaren Empfangsfrequenzbänder lückenlos aneinander anschließen oder sicher überlappen.

5. Funkwellenempfänger (1) nach einem der vorhergehenden Ansprüche, **dadurch gekennzeichnet, dass** zwischen dem Vorteiler (4) und dem Oszillator (3) ein Ansteuerteiler (5) vorgesehen ist.

6. funkwellenempfänger (1) nach Anspruch 5, **dadurch gekennzeichnet, dass** der Ansteuerteiler (5) einen fest eingestellten Teilerfaktor (A) hat, der nicht wahlweise selektierbar ist.

7. Funkwellenempfänger (1) nach einem der vorhergehenden Ansprüche, **dadurch gekennzeichnet, dass** der Ausgang des Oszillators (3) oder ein Ausgang des Vorteilers (4) mit einem Abstimmteiler (10) verbunden ist, der Ausgang des Abstimmteilers (10) mit einem ersten Eingang eines Phasenvergleichers (9) verbunden ist, ein zweiter Eingang des Phasenvergleichers (9) für ein Referenzfrequenzsignal vorgesehen ist, und der Ausgang des Phasenvergleichers (9) direkt oder indirekt in Verbindung mit einem Steuereingang des Oszillators (3) steht, wobei der Phasenvergleicher (9) zur Bestimmung der Phasendifferenz zwischen dem Ausgangssignal des Abstimmteilers (10) und dem Referenzfrequenzsignal und Bereitstellung eines Phasendifferenzsignals (V_{ref}) als Ausgangssignal ausgebildet ist.

8. Funkwellenempfänger (1) nach Anspruch 7, **gekennzeichnet durch** einen Referenzoszillator (6) und einen an den Ausgang des Referenzoszillators (6) geschalteten Referenzteilers (8) zur Erzeugung des Referenzfrequenzsignals.

9. Funkwellenempfänger (1) nach Anspruch 7 oder 8, **dadurch gekennzeichnet, dass** ein Schleifenfilter (11) zwischen dem Ausgang des Phasenvergleichers (9) und dem Steuereingang des Oszillators (3) vorgesehen ist.

10. Funkwellenempfänger (1) nach einem der vorhergehenden Ansprüche, **dadurch gekennzeichnet, dass** der Abstimmbereich oder mindestens eine Abstimmeigenschaft wie die Frequenzlage des Oszillators (3) ermittelt wird und die Teilerfaktoren des Vorteilers (4) und/oder Abstimmteilers (10) unter Berücksichtigung dieser ermittelten Abstimmeigenschaft(en) eingestellt werden.

11. Funkwellenempfänger (1) nach einem der vorhergehenden Ansprüche, **dadurch gekennzeichnet, dass** der Oszillator (3) mindestens eine wahlweise ein- oder ausschaltbare kapazitive Abstimmschaltung (13a, ..., 13n) zur Einstellung von Abstimmbereichen der Oszillatorfrequenz und mindestens eine kontinuierlich einstellbare kapazitive Abstimmschaltung (12) hat.

12. Funkwellenempfänger nach Anspruch 10 oder 11, der sich durch selbst Einmessen von Abstimmeigenschaften, insbesondere der Oszillatoreckfrequenzen die Einstellungen der Teiler und/oder Abstimmschaltung 13a,... , 13n wählt.

## Claims

1. Radio receiver (1) having a reception unit which can be set to selected reception frequencies and which has a mixer (2) for mixing the received signal (E) with a mixer signal (M) and an oscillator (3) for producing the mixer signal (M) at a selectively tuneable mixer actuation frequency, wherein the frequency of oscillation of the oscillator (3) is at least around three times greater than the greatest reception frequency provided for selection and a preliminary divider (4) having selectively adjustable division factors for reducing the frequency of oscillation of the oscillator (3) to the selected mixer actuation frequency is provided between the oscillator (3) and the mixer (2), **characterized in that** the mixer (2) is operated using either an overshooting or an undershooting mixer actuation signal (M).

2. Radio receiver (1) according to Claim 1, **characterized in that** the frequency of oscillation of the oscillator (3) and the division factors for the preliminary divider (4) are attuned to one another for the selection of different reception frequency bands.

3. Radio receiver (1) according to Claim 1 or 2, **characterized in that** at least two of the reception frequency bands which can be set by different division factors for the preliminary divider (4) overlap or adjoin one another without gaps.

4. Radio receiver (1) according to one of the preceding claims, **characterized in that** at least two of the reception frequency bands which can be set by virtue of undershooting or overshooting operation reliably overlap or adjoin one another without gaps.

5. Radio receiver (1) according to one of the preceding claims, **characterized in that** the preliminary divider (4) and the oscillator (3) have an actuation divider (5) provided between them.

6. Radio receiver (1) according to Claim 5, **characterized in that** the actuation divider (5) has a firmly set division factor (A) which cannot be selectively selected.

7. Radio receiver (1) according to one of the preceding claims, **characterized in that** the output of the oscillator (3) or an output of the preliminary divider (4) is connected to a tuning divider (10), the output of the tuning divider (10) is connected to a first input of a phase comparator (9), a second input of the phase comparator (9) is provided for a reference frequency signal, and the output of the phase comparator (9) is directly or indirectly connected to a control input of the oscillator (3), wherein the phase comparator (9) is designed to determine the phase difference between the output signal from the tuning divider (10) and the reference frequency signal and to provide a phase difference signal (V_{ref}) as an output signal.

8. Radio receiver (1) according to Claim 7, **characterized by** a reference oscillator (6) and a reference divider (8), connected to the output of the reference oscillator (6), for producing the reference frequency signal.

9. Radio receiver (1) according to Claim 7 or 8, **characterized in that** a loop filter (11) is provided between the output of the phase comparator (9) and the control input of the oscillator (3).

10. Radio receiver (1) according to one of the preceding claims, **characterized in that** the tuning range or at least one tuning property, such as the frequency, of the oscillator (3) is ascertained and the division factors of the preliminary divider (4) and/or tuning divider (10) are set taking account of this/these ascertained tuning property/properties.

11. Radio receiver (1) according to one of the preceding claims, **characterized in that** the oscillator (3) has at least one capacitive tuning circuit (13a, ..., 13n), which can be switched either on or off, for setting tuning ranges for the oscillator frequency, and at least one continuously adjustable capacitive tuning circuit (12).

12. Radio receiver according to Claim 10 or 11, which selects the settings for the dividers and/or tuning circuit 13a, ..., 13n by itself measuring tuning properties, particularly the oscillator corner frequencies.

## Revendications

1. Récepteur d'ondes radioélectriques (1) comprenant une unité de réception réglable sur des fréquences de réception sélectionnées, laquelle comprend un mélangeur (2) pour mélanger le signal reçu (E) avec un signal de mélangeur (M) et un oscillateur (3) pour générer le signal de mélangeur (M) avec une fréquence d'excitation de mélangeur accordable au choix, la fréquence d'oscillation de l'oscillateur (3) étant au moins trois fois plus grande que la plus grande fréquence de réception prévue pour la sélection et il est prévu entre l'oscillateur (3) et le mélangeur (2) un prédiviseur (4) avec des facteurs de division réglables au choix pour réduire la fréquence d'oscillation de l'oscillateur (3) à la fréquence d'excitation de mélangeur sélectionnée, **caractérisé en ce que** le mélangeur (2) fonctionne, au choix, avec un signal d'excitation de mélangeur (M) suroscillant ou sous-oscillant.

2. Récepteur d'ondes radioélectriques (1) selon la revendication 1, **caractérisé en ce que** la fréquence d'oscillation de l'oscillateur (3) et les facteurs de division pour le prédiviseur (4) sont accordés pour la sélection de différentes bandes de fréquence de réception.

3. Récepteur d'ondes radioélectriques (1) selon la revendication 1 ou 2, **caractérisé en ce qu'**au moins deux des bandes de fréquence de réception réglables par des facteurs de division différents pour le prédiviseur (4) sont directement juxtaposées l'une à l'autre ou se chevauchent.

4. Récepteur d'ondes radioélectriques (1) selon l'une des revendications précédentes, **caractérisé en ce qu'**au moins deux des bandes de fréquence de réception réglables par un fonctionnement en suroscillation ou en sous-oscillation sont directement juxtaposées l'une à l'autre ou se chevauchent.

5. Récepteur d'ondes radioélectriques (1) selon l'une des revendications précédentes, **caractérisé en ce qu'**un diviseur d'excitation (5) est prévu entre le prédiviseur (4) et l'oscillateur (3).

6. Récepteur d'ondes radioélectriques (1) selon la revendication 5, **caractérisé en ce que** le diviseur d'excitation (5) possède un facteur de division (A) réglé fixe qui ne peut pas être sélectionné au choix.

7. Récepteur d'ondes radioélectriques (1) selon l'une des revendications précédentes, **caractérisé en ce que** la sortie de l'oscillateur (3) ou une sortie du prédiviseur (4) est reliée avec un diviseur d'accord (10), la sortie du diviseur d'accord (10) est reliée avec une première entrée d'un comparateur de phase (9) et une deuxième entrée du comparateur de phase (9) est prévue pour un signal de fréquence de référence et la sortie du comparateur de phase (9) se trouve en liaison directe ou indirecte avec une entrée de commande de l'oscillateur (3), le comparateur de phase (9) étant configuré pour déterminer la différence de phase entre le signal de sortie du diviseur d'accord (10) et le signal de fréquence de référence et pour fournir un signal de différence de phase (V_{ref}) en tant que signal de sortie.

8. Récepteur d'ondes radioélectriques (1) selon la revendication 7, **caractérisé par** un oscillateur de référence (6) et un diviseur de référence (8) connecté à la sortie de l'oscillateur de référence (6) pour générer le signal de fréquence de référence.

9. Récepteur d'ondes radioélectriques (1) selon la revendication 7 ou 8, **caractérisé en ce qu'**un filtre en boucle (11) est prévu entre la sortie du comparateur de phase (9) et l'entrée de commande de l'oscillateur (3).

10. Récepteur d'ondes radioélectriques (1) selon l'une des revendications précédentes, **caractérisé en ce que** la plage d'accord ou au moins une propriété d'accord comme la position en fréquence de l'oscillateur (3) est déterminée et les facteurs de division du prédiviseur (4) et/ou du diviseur d'accord (10) sont réglés en tenant compte de cette ou de ces propriété(s) d'accord déterminée(s).

11. Récepteur d'ondes radioélectriques (1) selon l'une des revendications précédentes, **caractérisé en ce que** l'oscillateur (3) possède au moins un circuit d'accord capacitif (13a, ..., 13n) pouvant être activé ou désactivé au choix pour régler les plages d'accord de la fréquence de l'oscillateur et au moins un circuit d'accord capacitif (12) réglable en continu.

12. Récepteur d'ondes radioélectriques (1) selon la revendication 10 ou 11, lequel sélectionne les réglages du diviseur et/ou du circuit d'accord 13a, ..., 13n par auto-mesure des propriétés d'accord, notamment des fréquences limites de l'oscillateur.
